# EUROPÄISCHE PATENTSCHRIFT

(11) **EP 1 760 169 B1**
(45) Veröffentlichungstag und Bekanntmachung des Hinweises auf die Patenterteilung: **16.04.2008**
(21) Anmeldenummer: 05016832.7
(22) Anmeldetag: 03.08.2005
(51) Int. Cl.: C23C 14/24, H05B 3/60

(54) **Verdampfervorrichtung zum Beschichten von Substraten**
Evaporator for coating of substrates
Evaporateur pour le revêtement de substrats

(43) Veröffentlichungstag der Anmeldung: 07.03.2007
(73) Patentinhaber: Applied Materials GmbH & Co. KG, 63755 Alzenau (DE)
(72) Erfinder: Klemm, Günter, 63667 Nidda (DE); Bender, Marcus, 63456 Hanau (DE); Englert, Ulrich, 63869 Heigenbrücken (DE); Klöppel, Andreas, 63695 Glauburg (DE); Hoffmann, Uwe, 63755 Alzenau (DE); Lotz, Hans-Georg, 63584 Gründau-Rothenbergen (DE); Hein, Stefan, 63825 Blankenbach (DE); Keller, Stefan, 63814 Mainaschaff (DE)
(74) Vertreter: Schickedanz, Willi

(56) Entgegenhaltungen:
- EP-A- 1 327 699
- DE-C- 880 529
- US-A- 2 909 149
- US-A- 3 020 177
- US-A- 3 582 611
- PATENT ABSTRACTS OF JAPAN Bd. 007, Nr. 011 (C-145), 18. Januar 1983 (1983-01-18) & JP 57 169088 A (OLYMPUS KOGAKU KOGYO KK), 18. Oktober 1982 (1982-10-18)

## Beschreibung

Die Erfindung betrifft eine Verdampfervorrichtung zum Beschichten von Substraten mit wenigstens einem Material.

Das Beschichten eines Substrats mit einem Material kann, neben dem elektrolytischen Verfahren, auch durch Sputtern oder durch Bedampfen erfolgen. Die so entstandene Schicht dient oft dem Schutz des beschichteten Materials, wobei sie aber auch rein dekorative oder funktionale Bedeutung haben kann.

Das Aufbringen einer Schicht durch Bedampfen spielt insbesondere bei der Beschichtung von Substraten mit Metallen eine große Rolle. Dabei wird ein Metall in einem Tiegel geschmolzen, wobei die Temperatur so gewählt ist, dass das Metall in den gasförmigen Zustand übergeht und in Richtung des zu beschichtenden Substrats wandert, wo es kondensiert.

So sind für das Beschichten von Substraten Verdampfungsanlagen bekannt, bei denen in einem evakuierten Raum mehrere Verdampferschiffchen untergebracht sind. In diese Verdampferschiffchen wird - häufig in einem kontinuierlichen Prozess - Material in Form eines Drahts eingebracht, welches verdampft. Dieser Dampf steigt auf und kondensiert auf dem zu beschichtenden Substrat, wobei das Substrat, oft als Band, über die Verdampferschiffchen geführt ist. Nachteilig ist bei dieser Verdampferanlage, dass sich beim direkten Verdampfen Spritzer bilden, da durch Verunreinigungen und gasförmige Anteile unregelmäßige Dampfdrücke erzeugt werden. Die Spritzer entstehen ferner durch schnelle Bewegung der Schmelze in heißen Zonen der Verdampferschiffchen. Das zum Teil diskontinuierliche Abschmelzen des Drahts führt außerdem zu unterschiedlichen Abdampfraten, weil diese vom Auftreffort des Drahts abhängig sind.

Aus der DE 40 27 034 C1 ist eine Verdampfervorrichtung zum Beschichten von bandförmigen Substraten in einer Vakuumbeschichtungskammer bekannt. Die dort verwendeten Verdampferschiffchen bilden eine Verdampferbank, wobei die Schiffchen längs zur Bandlaufrichtung und parallel in etwa gleich großen Abständen zueinander angeordnet sind.

Des Weiteren ist aus der DE 44 04 550 C2 eine Anordnung zur Regelung der Verdampferrate von Tiegeln bekannt, die durch Stromdurchfluss erhitzt werden, wobei mit diesen Tiegeln Metall verdampft wird. Die Regelung der Verdampferrate erfolgt in diesem Fall über eine elektrische Widerstandsheizung, wobei sich der Gesamtwiderstand aus dem elektrischen Widerstand des Tiegels und aus dem elektrischen Widerstand des Materials in dem Tiegel ergibt.

Es ist außerdem eine Vorrichtung zum Verdampfen von Metall bekannt, wobei ein Draht in eine Rinne, die in Fließverbindung mit einem Verdampfertiegel in Verbindung steht, eingebracht wird (DE 34 28 651 A1). Beim Schmelzen des Drahts kann es durch Verunreinigungen und gasförmige Anteile wegen der unterschiedlichen Dampfdrücke zu Spritzern kommen, die auf das Substrat gelangen. Um dies zu vermeiden, ist oberhalb der Rinne eine gekühlte Abschirmung oder Abdeckung angebracht. Dadurch wird gewährleistet, dass das Substrat nur durch das aus dem Verdampfertiegel aufsteigende Material beschichtet wird.

Weiterhin sind auch noch Verdampferschiffchen bekannt, bei denen sich zwischen einer ersten Zone und einer zweiten Zone eine Abschirmung in Form einer Wand befindet. Diese Wand soll verhindern, dass die beim Schmelzen des Metalls entstehenden Spritzer auf das zu beschichtende Substrat gelangen können (US 3 467 058, EP 0 430 210 B1).

Schließlich ist auch noch eine Verdampfervorrichtung bekannt, die eine Einschmelzzone, eine Verdampferzone und eine Verbindung zwischen beiden Zonen aufweist (US 3 020 177 A; JP 57/69088; EP 1 327 699 A).

Die der Erfindung zugrunde liegende Aufgabe besteht darin, eine Verdampfervorrichtung zum Beschichten von Substraten mit Materialien, insbesondere von Metallen, bereitzustellen, die so konzipiert ist, dass keine Spritzer auf das Substrat gelangen können, wobei der Einbau von Wänden oder anderweitigen Abschirmungen nicht notwendig ist.

Diese Aufgabe wird gemäß den Merkmalen des Anspruchs 1 gelöst.

Die Erfindung betrifft somit eine Verdampfervorrichtung mit einem Tiegel, wobei der Tiegel in wenigstens drei Zonen aufgeteilt ist, die jeweils auf verschiedene Temperaturen aufgeheizt werden. Bei der ersten Zone handelt es sich um eine Einschmelzzone und bei der zweiten Zone um die Erwärmungszone und bei der dritten Zone um die Verdampferzone. Die Verdampfervorrichtung ist vorzugsweise für das Verdampfen von Metallen geeignet. Werden Metalle verdampft, so wird vorzugsweise ein Metalldraht in die Einschmelzzone geführt. Es können jedoch auch Metalllegierungen verdampft werden, indem man einen oder mehrere aus unterschiedlichen Materialien bestehende Metalldrähte in die Einschmelzzone einführt.

Der mit der Erfindung erzielte Vorteil besteht insbesondere darin, dass eine spritzerfreie und sehr gleichmäßige Abdampfrate für qualitativ hochwertige Schichten auf organischen Substraten, z. B. OLEDs, und Kunststofffolien erzielt wird. Dies ist beispielsweise bei der Herstellung von Kondensatoren, wo spritzerfreie Schichten bei guter Gleichmäßigkeit und geringer Strahlungsbelastung auf Dünnstfolien aufgebracht werden müssen, von Bedeutung. Vorteilhaft ist auch, dass an die Genauigkeit der Drahtführung keine hohen Anforderungen gestellt werden müssen, weil der Auftreffpunkt des Drahts auf dem erhitzten Tiegel für die Abdampfrate unwichtig ist. Da in der Einschmelzzone niedrigere Temperaturen als in der Verdampferzone herrschen, wird auch die Drahtführung thermisch wenig belastet und wenig bedampft. Durch die Aufteilung in Einschmelz- und Verdampferzone können Verunreinigungen wie Schmutz oder Oxidschichten von der Verdampferzone weitgehend ferngehalten werden. Die Lebensdauer des Tiegels wird ebenfalls erhöht, weil sich das flüssige zu verdampfende Material nur langsam bewegt.

Ausführungsformen der Erfindung sind in den Zeichnungen dargestellt und werden im Folgenden näher erläutert. Es zeigen:
Fig. 1 eine perspektivische Ansicht einer Verdampfervorrichtung mit drei Zonen;
Fig. 2 eine perspektivische Ansicht einer Variante der in Fig. 1 gezeigten Vorrichtung, wobei jede der drei Zonen eine separate Heizung aufweist;
Fig. 3 eine Draufsicht auf die Verdampfervorrichtung gemäß Fig. 2;
Fig. 4 einen Schnitt der Verdampfervorrichtung gemäß Fig. 3 entlang A-A;
Fig. 5 einen Schnitt durch eine andere Ausführungsform der Verdampfervorrichtung;
Fig. 6 eine Verdampferbank mit mehreren Verdampferschiffchen.

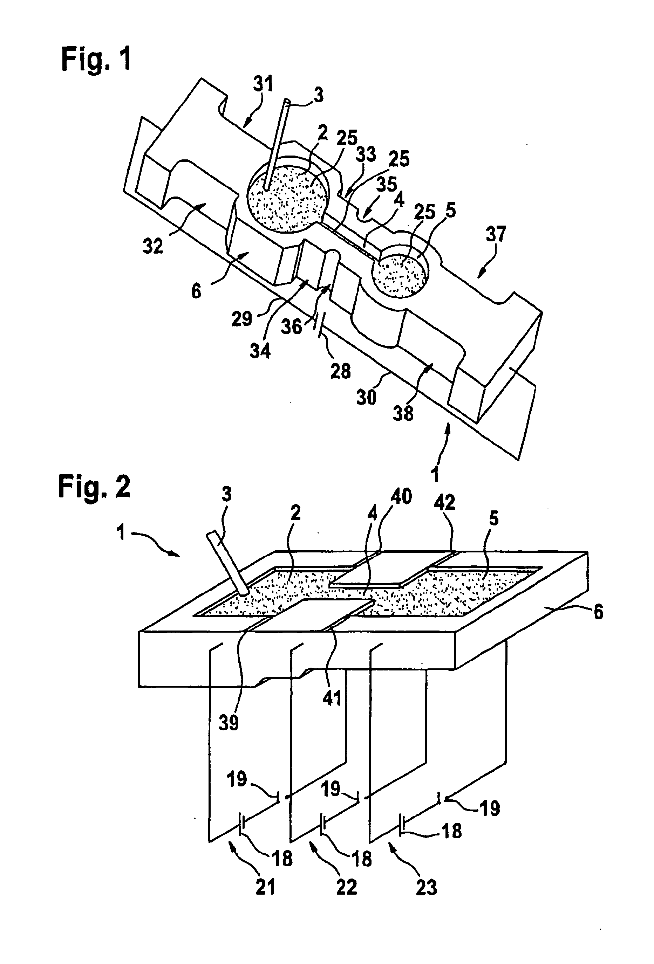

Fig. 1 zeigt eine perspektivische Ansicht einer Verdampfervorrichtung 1 mit einem Tiegel 6, der aus drei Zonen besteht. Dabei wird in die erste Zone 2, die so genannte Einschmelzzone, das zu verdampfende Material eingebracht, wo es geschmolzen wird. Handelt es sich bei dem Material um ein Metall, so kann dieses in Form eines Drahts 3 in die Einschmelzzone 2 eingebracht werden.

Der Draht 3 kann sich, wie zum Beispiel in US 3 467 058, auf einer Rolle befinden, von der er kontinuierlich in die Einschmelzzone 2 eingeführt wird. Soll eine Legierung auf das Substrat aufgebracht werden, so kann der Draht 3 bereits diese Legierung aufweisen, oder es kann die Legierung durch gleichzeitiges Schmelzen mehrerer Drähte der gewünschten Metalle, welche die Legierung bilden sollen, hergestellt werden.

Dabei spielt es keine Rolle, wie der Draht 3 in die Einschmelzzone 2 eingeführt wird, da an die Genauigkeit der Drahtführung keine großen Anforderungen gestellt werden.

Vorzugsweise sollen mit dieser Verdampfervorrichtung 1 solche Metalle bzw. deren Legierungen verdampft werden, die Ag, Cu, Al enthalten.

Auf die Einschmelzzone 2 des Tiegels 6 folgt eine so genannte Erwärmungszone 4, in der eine Temperatur herrscht, welche die Siedetemperatur des Metalls mit dem niedrigsten Siedepunkt nicht erreichen darf, die aber höher als die Temperatur der Einschmelzzone 2 ist. In dieser Erwärmungszone 4 werden niedrig siedende Verunreinigungen entfernt, sodass Metalle erhalten werden, die einen sehr hohen Reinheitsgrad besitzen.

Die Erwärmungszone 4 des Tiegels 6 weist eine Form auf, die an das Material der Schmelze 25 und die jeweiligen temperaturabhängigen Oberflächenspannungen angepasst ist. Oft hat sie dabei die Form eines Kanals, wie hier dargestellt, der die Einschmelzzone 2 mit einer Verdampferzone 5 verbindet. Die Erwärmungszone 4 ist kleiner als die Zonen 2 und 5 und verhindert, dass es zu einem Austausch der Schmelze 25 in den Zonen 2 und 5 kommt, da es wichtig ist, den kälteren Bereich 2 vom heißeren Bereich 5 getrennt vorliegen zu haben, denn es soll vermieden werden, dass es bereits in der Einschmelzzone 2 zur Verdampfung kommt. Die Größe der Erwärmungszone 4 ist materialabhängig, sie kann in der Praxis z. B. eine Länge von 10 mm aufweisen. Die Temperatur der Schmelze 25 steigt von der Zone 2 bis hin zur Zone 5 stetig an.

Nachdem die Schmelze 25 die Erwärmungszone 4 des Tiegels 6 passiert hat, gelangt sie in die Verdampferzone 5, wo das Material schließlich auf das Substrat aufgedampft wird, welches über der Verdampferzone 5 angeordnet ist.

Das Material des Tiegels 6 muss einen Schmelzpunkt haben, der weit oberhalb der Verdampfungstemperatur des Metalls liegt, welches es zu verdampfen gilt. Als Materialien für den Tiegel 6 kommen hoch schmelzende Verbindungen in Frage, wobei der Tiegel 6 auch aus mehreren Verbindungen dieser Art bestehen kann. Neben Graphit können beispielsweise Verbindungen der metallischen Boride, Nitride oder Carbide sowie Verbindungen der nicht metallischen Boride, Nitride oder Carbide verwendet werden. Auch TiB₂ zusammen mit BN sind als Material des Tiegels 6 geeignet.

Dabei wird der Tiegel 6 in der Form beheizt, dass die Temperatur im Bereich 2 am niedrigsten und im Bereich 5 am höchsten ist, wobei das Heizen über nur eine oder über mehrere separat voneinander betriebene Heizungen erfolgen kann.

Bei dem in der Fig. 1 gezeigten Ausführungsbeispiel erfolgt die Aufheizung durch einen Strom, der durch den Tiegel 6 fließt, und zwar in dessen Längsrichtung. Hierzu ist eine Spannungsquelle 28 über Leitungen 29, 30 an die Enden des Tiegels 6 angeschlossen. Aufgrund von Aussparungen 31 bis 38 an den Seiten des Tiegels 6 ergeben sich verschiedene elektrische Widerstände an den verschiedenen Zonen. An denjenigen Zonen, an denen der Tiegel 6 sehr schmal ist, ergibt sich ein hoher elektrischer Widerstand und damit eine hohe Temperatur, weil diese Temperatur gemäß der Formel W = R I² zum elektrischen Widerstand proportional ist, wobei W = elektrische Leistung, R = Widerstand und I = Stromstärke. Da die elektrische Leistung zur Temperatur proportional ist, ergibt sich somit ein Zusammenhang zwischen der Querschnittsbreite des Tiegels 6 und der dort herrschenden Temperatur. Es ist nun möglich, die Form des Tiegels 6 so zu berechnen, dass sich an bestimmten Stellen bestimmte Temperaturen einstellen, beispielsweise von 1200 °C in der Einschmelzzone 2, von 1260 °C bis 1496 °C in der Erwärmungszone 4 und 1560 °C in der Verdampferzone 5. Die jeweiligen Temperaturen sind indessen von dem jeweils zu verdampfenden Material abhängig. Damit kann auch die Geometrie des Tiegels 6 von Material zu Material verschieden sein.

Für Aluminium gilt beispielsweise, dass die Temperatur in der Einschmelzzone 2 um ca. 300 bis 500 °C oberhalb des Schmelzpunkts und in der Verdampferzone 5 um ca. 900 °C oberhalb des Schmelzpunkts liegt. Die Temperaturen in den Zonen 2 und 4 werden so gewählt, dass es dort nicht zur Verdampfung von Material kommt. Theoretisch würde es genügen, dass die Temperatur in der Einschmelzzone nur knapp über der Schmelztemperatur liegt. Da jedoch der eingeführte Metalldraht zu einer Abkühlung führt, wählt man die Temperatur in der Einschmelzzone höher.

Es versteht sich, dass die Widerstandsverhältnisse nicht nur durch seitliche Einbuchtungen des Tiegels 6 erreicht werden können, sondern auch durch unterschiedliche Dicken des Tiegelmaterials in vertikaler Richtung. Wesentlich ist der jeweilige Gesamtquerschnitt, der für den elektrischen Widerstand verantwortlich ist.

Die aufsteigende Dampfkeule des zu verdampfenden Metalls bleibt während der Verdampfung nahezu konstant, wodurch die Beschichtung sehr gleichmäßig wird. Bilden mehrere Verdampferschiffchen eine Verdampferbank, werden die Verdampferschiffchen so ausgerichtet, dass das Substrat gleichmäßig beschichtet wird. Dies kann nicht nur durch die Anordnung der Verdampferschiffchen zueinander, sondern auch dadurch erreicht werden, dass das Substrat in einer solchen Entfernung über die Verdampferbank geführt wird, dass es zu einer gleichmäßigen Beschichtung kommt.

Durch die Trennung der Verdampferzone 5 von der Einschmelzzone 2 ist die Bewegung von flüssigem Metall in der Verdampferzone 5 selbst sehr gering, wodurch auch die Verdampfervorrichtung 1 eine höhere Lebensdauer besitzt.

Die Abdampfrate kann über die Geschwindigkeit des Abschmelzens des Drahts und die Geometrie des Tiegels 6 gesteuert werden. Für den kontinuierlichen Betrieb der Verdampfervorrichtung 1 kann eine Regelung des Füllstands der Schmelze 25, des Drahtvorschubs und der Verdampferleistung vorgesehen sein.

Da die Abdampfrate sehr gleichmäßig ist und es zu keinen Spritzern kommt, die auf das Substrat gelangen können, eignet sich eine solche Verdampfervorrichtung 1 zum Beschichten von z. B. Kunststofffolien mit Metall. Die Verdampferrate bestimmt sich dabei über die Oberfläche der Verdampferzone 5, die Temperatur des Verdampfertiegels sowie die Drahtzufuhr, d. h. die Menge an geschmolzenem Draht 3 pro Zeiteinheit. So kann eine solche Vorrichtung für die Kondensatoranfertigung eingesetzt werden, da hier spritzerfrei Schichten auf Dünnstfolien aufgebracht werden und die Schichten zudem sehr gleichmäßig sein müssen.

Ein weiteres Einsatzgebiet ist auch die Herstellung von Metallic Yarn, da auch hier die Anforderungen an die Verdampfervorrichtung 1 sehr hoch sind.

Fig. 2 zeigt eine perspektivische Ansicht einer Variante der in der Fig. 1 gezeigten Verdampfervorrichtung 1, wobei die Einschmelzzone 2, die Erwärmungszone 4 und die Verdampferzone 5 des Tiegels 6 jeweils über eine eigene elektrische Widerstandsheizung 21, 22, 23 verfügen. Damit können die drei Zonen auf verschiedene Temperaturen gebracht werden. Zwischen den einzelnen Zonen 2, 4 bzw. 4, 5 befinden sich Isolierschichten 39 bis 42, sodass die Ströme eindeutig in Querrichtung fließen. Die Gleichspannungsquellen 18 liegen dann alle an einem eigenen Widerstand, an den sie über Schalter 19 gelegt werden können. Statt konstanter Gleichspannungsquellen 18 können auch regelbare Gleichspannungsquellen eingesetzt werden. Außerdem können Wechselspannungsquellen verwendet werden.

Statt dreier getrennter Spannungsquellen 18 kann auch nur eine Spannungsquelle vorgesehen sein, zu der die drei Zonen 2, 4, 5 parallel geschaltet sind. Um hier in verschiedenen Zonen unterschiedliche Temperaturen zu erzeugen, können die Zonen aus verschiedenen Materialien bestehen oder unterschiedliche Stromfluss-Querschnitte haben.

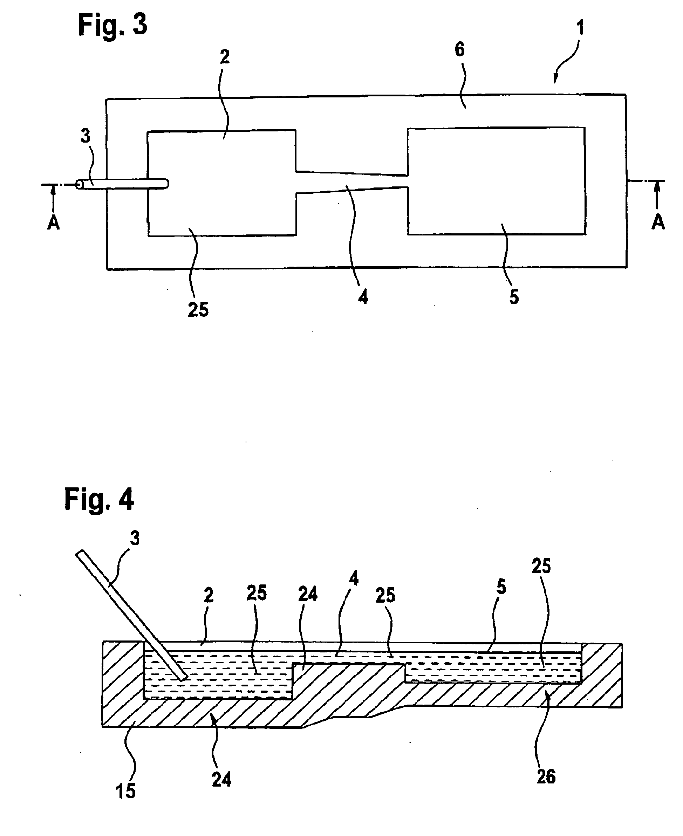

Fig. 3 zeigt eine Draufsicht der in Fig. 2 gezeigten Verdampfervorrichtung 1. Zu erkennen ist, dass der Draht 3 schräg von oben in die Einschmelzzone 2 eingeführt wird, wo das Metall oder die Legierung schmilzt. Diese Schmelze 25 wandert über die Erwärmungszone 4 in die Verdampferzone 5, wo es schließlich zur Verdampfung kommt. Deutlich zu erkennen ist die zur Verdampferzone 5 schmaler werdende Erwärmungszone 4, die als Kanal ausgebildet ist. Dieser Kanal ist so geformt, wie es das geschmolzene Material und dessen temperaturabhängige Oberflächenspannung erfordert.

Fig. 4 zeigt einen Schnitt entlang A-A in Fig. 3. Der Draht 3 wird in die Einschmelzzone 2 gebracht, die über die Erwärmungszone 4 mit der Verdampferzone 5 verbunden ist. Das Becken 24 der Einschmelzzone 2 ist dabei tiefer als das Becken 26 der Verdampferzone 5. Da der Boden der Erwärmungszone 4 oberhalb des Bodens der Einschmelzzone 2 liegt, kann erst dann das geschmolzene Metall in die Verdampferzone 5 fließen, wenn genug Metall vom Draht abgeschmolzen wurde, um den Pegel zu erreichen, der mindestens der Höhe der Erwärmungszone 4 entspricht. Der Boden des Beckens 26 der Verdampferzone 5 liegt unterhalb des Bodens der Erwärmungszone 4.

Die Becken der verschiedenen Zonen können jedoch auch alle auf gleichem Niveau liegen, oder es können nur die Becken der Zonen 4 und 5 auf gleichem Niveau liegen. Ein Materialfluss von der Einschmelzzone 2 zur Verdampferzone 5 findet auch in diesem Fall statt, weil sich der Pegel des in der Verdampferzone 5 befindlichen Materials aufgrund des Verdampfens senkt und damit Material aus der Einschmelzzone 2 nachzieht.

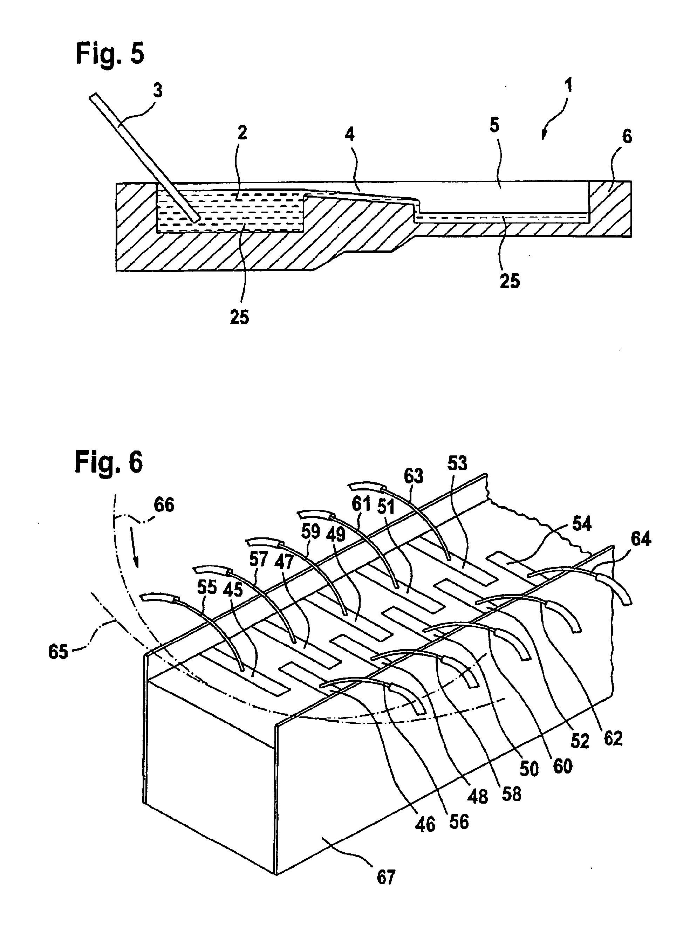

Die Fig. 5 zeigt eine Variante der in Fig. 4 gezeigten Vorrichtung. Im Unterschied zu der in Fig. 4 gezeigten Verdampfervorrichtung besitzt die Erwärmungszone 4 zur Verdampferzone 5 hin ein Gefälle.

In der Fig. 6 ist gezeigt, wie mehrere Tiegel bzw. Verdampferschiffchen 45 bis 54 in einer Beschichtungsanlage angeordnet sein können. Jedes Verdampferschiffchen 45 bis 54 wird dabei mit einem eigenen Draht 55 bis 64 beschickt, und zwar über nicht dargestellte Drahtzuführungen. Das zu beschichtende Substrat ist hier eine Folie 65, die über eine nur angedeutete Beschichtungswalze 66 in den Verdampferschiffchen vorbeigeführt wird. Die Bewegungsrichtung der Folie 65 entspricht dabei der Längsrichtung der Verdampferschiffchen. Die drei Zonen der Verdampferschiffchen 45 bis 54 sind in der Fig. 6 nicht dargestellt.

Die Verdampferschiffchen 45 bis 54 sind auf einer Verdampferbank 67 angeordnet, die unter die Beschichtungswalze 66 geschoben werden kann. Es ist jedoch auch vorstellbar, dass die Verdampferschiffchen 45 bis 54 auf einem Einschub angeordnet sind, der ebenfalls unter eine Beschichtungswalze geschoben werden kann.

In der Fig. 6 sind alle Verdampferschiffchen 45 bis 54 offen, d. h. es sind keine Bereiche von ihnen abgedeckt.

Es ist aber auch möglich, über der Verdampferzone 5 des Tiegels gemäß Fig. 1 ein Verteilerrohr senkrecht über der Verdampferzone 5 anzuordnen, wobei dieses Verteilerrohr zahlreiche in vertikaler Richtung und linear angeordnete Durchbohrungen aufweist, über die der Dampf auf ein Substrat gelenkt wird. Ein solches Verteilerrohr ist beispielsweise aus der DE 102 56 038 A1 bekannt.

Anstelle von elektrischen Widerstandsheizungen können auch induktive Heizungen vorgesehen werden, die so ausgelegt sind, dass sie in verschiedenen Zonen eines Verdampferschiffchens verschiedene Temperaturen erzeugen.

## Patentansprüche

1. Verdampfervorrichtung zum Beschichten von Substraten mit wenigstens einem Material, enthaltend wenigstens einen Tiegel mit
a) einer Einschmelzzone (2)
b) einer Verdampferzone (5)
c) einer Verbindung zwischen Einschmelzzone (2) und Verdampferzone (5)
d) einer Heizeinrichtung (28, 18), die es ermöglicht, die Einschmelzzone (2) und die Verdampferzone (5) auf jeweils verschiedene Temperaturen aufzuheizen,
**dadurch gekennzeichnet, dass** die Verbindung zwischen der Einschmelzzone (2) und der Verdampferzone (5) eine kanalförmige Erwärmungszone (4) ist, deren Durchmesser senkrecht zur Längsrichtung der Verdampfervorrichtung kleiner ist als der Durchmesser der Einschmelzzone (2) und der Verdampferzone (5), und dass es die Heizeinrichtung (28, 18) ermöglicht, die Erwärmungszone (4) auf eine Temperatur aufzuheizen, die zwischen der Temperatur der Einschmelzzone (2) und der Temperatur der Verdampferzone (5) liegt.

2. Verdampfervorrichtung nach Anspruch 1, **dadurch gekennzeichnet, dass** der Tiegel (6) elektrisch leitend ist und die Heizeinrichtung durch eine Spannungsquelle (28) in Verbindung mit der Geometrie senkrecht zur Längsrichtung des Tiegels (6) und dem Material des Tiegels (6) gebildet ist, wobei die Spannungsquelle (28) an den Enden des Tiegels (6) anliegt.

3. Verdampfervorrichtung nach Anspruch 1, **dadurch gekennzeichnet, dass** die Einschmelzzone (2), die Erwärmungszone (4) und die Verdampferzone (5) des Tiegels (6) durch Isolierschichten voneinander getrennt sind und jeder Zone eine Spannungsquelle (18) zugeteilt ist.

4. Verdampfervorrichtung nach Anspruch 1, **dadurch gekennzeichnet, dass** die Aufheizung der Zonen (2, 4, 5) auf verschiedene Temperaturen mittels induktiver Erwärmung erfolgt.

5. Verdampfervorrichtung nach Anspruch 1, **dadurch gekennzeichnet, dass** die Temperatur in der Erwärmungszone (4) von der Einschmelzzone (2) in Richtung auf die Verdampferzone (5) stetig zunimmt.

6. Verdampfervorrichtung nach Anspruch 1, **dadurch gekennzeichnet, dass** die Zonen (2, 4, 5) durch verschiedene geometrische Querschnitte des Tiegels (6) gebildet sind, wodurch der elektrische Widerstand in den Zonen (2, 4, 5) variiert.

7. Verdampfervorrichtung nach Anspruch 1, **dadurch gekennzeichnet, dass** die Zonen (2, 4, 5) aus Materialien von unterschiedlicher elektrischer Leitfähigkeit bestehen.

8. Verdampfervorrichtung nach Anspruch 1, **dadurch gekennzeichnet, dass** die Erwärmungszone (4) kanalähnlich ausgebildet ist.

9. Verdampfervorrichtung nach Anspruch 1, **dadurch gekennzeichnet, dass** die Einschmelzzone (2) und die Verdampferzone (5) zylindertopfförmig ausgebildet sind.

10. Verdampfervorrichtung nach Anspruch 1, **dadurch gekennzeichnet, dass** die tiefsten Stellen der Zonen (2, 4, 5) auf verschiedenem Niveau liegen.

11. Verdampfervorrichtung nach Anspruch 1, **dadurch gekennzeichnet, dass** die tiefsten Stellen der Zonen (2, 4, 5) auf gleichem Niveau liegen.

12. Verdampfervorrichtung nach Anspruch 1, **dadurch gekennzeichnet, dass** die tiefste Stelle der Erwärmungszone (4) auf einem höheren Niveau als die tiefsten Stellen der Einschmelzzone (2) und der Verdampferzone (5) liegt.

13. Verdampfervorrichtung nach Anspruch 12, **dadurch gekennzeichnet, dass** die Erwärmungszone (4) ein Gefälle in Richtung auf die Verdampferzone (5) aufweist.

14. Verdampfervorrichtung nach Anspruch 1, **dadurch gekennzeichnet, dass** die Einschmelzzone (2) und die Verdampferzone (5) eine rechteckige Grundform aufweisen.

15. Verdampfervorrichtung nach Anspruch 1, **dadurch gekennzeichnet, dass** die Einschmelzzone (2) und die Verdampferzone (5) eine runde Grundform aufweisen.

16. Verdampfervorrichtung nach Anspruch 1, **dadurch gekennzeichnet, dass** der Tiegel (6) aus einer hochschmelzenden Verbindung besteht, die den metallischen Boriden, Nitriden und/oder Carbiden sowie den nicht metallischen Boriden, Nitriden und/oder Carbiden und/oder Graphit oder Mischungen aus diesen angehört.

17. Verdampfervorrichtung nach Anspruch 16, **dadurch gekennzeichnet, dass** der Tiegel (6) TiB₂ und BN aufweist.

18. Verdampfervorrichtung nach Anspruch 1, **dadurch gekennzeichnet, dass** sie zum Verdampfen von Metallen verwendet wird.

19. Verdampfervorrichtung nach Anspruch 1, **dadurch gekennzeichnet, dass** mehrere Tiegel (45 - 54) nebeneinander angeordnet sind und sich ein Substrat (65) entlang der Längsachse dieser Tiegel (45 - 54) bewegt.

20. Verdampfervorrichtung nach Anspruch 19, **dadurch gekennzeichnet, dass** für jeden Tiegel (45 - 54) eine eigene Zuführung für einen Draht (55 - 64) vorgesehen ist, wobei das Ende dieses Drahts (55 - 64) in die Einschmelzzone (2) eines Tiegels (45 - 54) geführt ist.

## Claims

1. Evaporator device for coating substrates with at least one material, containing at least one crucible with
a) a melting zone (2)
b) an evaporator zone (5)
c) a connection between melting zone (2) and evaporator zone (5)
d) a heating device (28, 18) which permits the melting zone (2) and the evaporator zone (5) to be heated to respectively different temperatures,
**characterised in that** the connection between the melting zone (2) and the evaporator zone (5) is a channel-shaped heating zone (4) whose diameter perpendicular to the longitudinal direction of the evaporator device is smaller than the diameter of the melting zone (2) and the evaporator zone (5) and that the heating device (28, 18) permits the heating zone (4) to be heated to a temperature which lies between the temperature of the melting zone (2) and the temperature of the evaporator zone (5).

2. The evaporator device according to claim 1, **characterised in that** the crucible (6) is electrically conducting and the heating device is formed by a voltage source (28) in conjunction with the geometry perpendicular to the longitudinal direction of the crucible (6) and the material of the crucible (6), wherein the voltage source (28) abuts against the ends of the crucible (6).

3. Evaporator arrangement as claimed in claim 1, **characterized in that** the melt-down zone (2), the heating zone (4) and the evaporator zone (5) of the crucible (6) are separated from one another by insulating layers and to each zone one voltage source (18) is assigned.

4. Evaporator arrangement as claimed in claim 1, **characterized in that** the heating of the zones (2, 4, 5) to different temperatures takes place by means of inductive heating.

5. Evaporator arrangement as claimed in claim 1, **characterized in that** the temperature in the heating zone (4) increases continuously from the melt-down zone (2) in the direction toward the evaporator zone (5).

6. Evaporator arrangement as claimed in claim 1, **characterized in that** the zones (2, 4, 5) are formed by different geometric cross sections of the crucible (6), whereby the electrical resistance in the zones (2, 4, 5) varies.

7. Evaporator arrangement as claimed in claim 1, **characterized in that** the zones (2, 4, 5) are comprised of materials of different electrical conductivity.

8. Evaporator arrangement as claimed in claim 1, **characterized in that** the heating zone (4) is developed similarly to a channel.

9. Evaporator arrangement as claimed in claim 1, **characterized in that** the melt-down zone (2) and the evaporator zone (5) are formed in the shape of a cylindrical pot.

10. Evaporator arrangement as claimed in claim 1, **characterized in that** the deepest sites of the zones (2, 4, 5) are at different levels.

11. Evaporator arrangement as claimed in claim 1, **characterized in that** the deepest sites of the zones (2, 4, 5) are at the same level.

12. Evaporator arrangement as claimed in claim 1, **characterized in that** the deepest site of the heating zone (4) is at a higher level than the deepest sites of the melt-down zone (2) and of the evaporator zone (5).

13. Evaporator arrangement as claimed in claim 12, **characterized in that** the heating zone (4) has a gradient in the direction toward the evaporator zone (5).

14. Evaporator arrangement as claimed in claim 1, **characterized in that** the melt-down zone (2) and the evaporator zone (5) have a rectangular base.

15. Evaporator arrangement as claimed in claim 1, **characterized in that** the melt-down zone (2) and the evaporator zone (5) have a circular base.

16. Evaporator arrangement as claimed in claim 1, **characterized in that** the crucible (6) is comprised of a high-melting compound from the metallic borides, nitrides and/or carbides as well as the nonmetallic borides, nitrides and/or carbides and/or graphite or mixtures thereof.

17. Evaporator arrangement as claimed in claim 16, **characterized in that** the crucible (6) includes TiB₂ and BN.

18. Evaporator arrangement as claimed in claim 1, **characterized in that** it is employed for the evaporation of metals.

19. Evaporator arrangement as claimed in claim 1, **characterized in that** several crucibles (45-54) are disposed one next to the other and a substrate (65) moves along the longitudinal axis of these crucibles (45-54).

20. Evaporator arrangement as claimed in claim 19, **characterized in that** for each crucible (45-54) a separate supply for a wire (55-64) is provided, wherein the end of this wire (55-64) is guided into the melt-down zone (2) of a crucible (45-54).

## Revendications

1. Dispositif de vaporisation pour le revêtement de substrats au moyen d'au moins un matériau, comportant au moins un creuset, comprenant
a) une zone de fusion (2),
b) une zone de vaporisation (5),
c) un raccordement entre la zone de fusion (2) et la zone de vaporisation (5),
c) un dispositif de chauffage (28, 18) qui permet de chauffer la zone de fusion (2) et la zone de vaporisation (5) à des températures respectivement différentes,
**caractérisé en ce que** le raccordement entre la zone de fusion (2) et la zone de vaporisation (5) est une zone de réchauffement en forme de canal (4) dont le diamètre, perpendiculairement au sens longitudinal du dispositif de vaporisation, est inférieur au diamètre de la zone de fusion (2) et de la zone de vaporisation (5) et que le dispositif de chauffage (28, 18) permet de chauffer la zone de réchauffement (4) à une température qui se situe entre la température de la zone de fusion (2) et la température de la zone de vaporisation (5).

2. Dispositif de vaporisation selon la revendication 1, **caractérisé en ce que** le creuset (6) est conducteur électrique et que le dispositif de chauffage est constitué par une source de tension (28) en liaison avec la géométrie perpendiculairement au sens longitudinal du creuset (6) et le matériau du creuset (6), la source de tension (28) étant en contact avec les extrémités du creuset (6).

3. Dispositif de vaporisation selon la revendication 1, **caractérisé en ce que** la zone de fusion (2), la zone de réchauffement (4) et la zone de vaporisation (5) du creuset (6) sont séparées les unes des autres par des couches isolantes et qu'une source de tension (18) est affectée à chaque zone.

4. Dispositif de vaporisation selon la revendication 1, **caractérisé en ce que** le chauffage des zones (2, 4, 5) à différentes températures a lieu par réchauffement inductif.

5. Dispositif de vaporisation selon la revendication 1, **caractérisé en ce que** la température dans la zone de réchauffement (4) augmente constamment depuis la zone de fusion (2) en direction de la zone de vaporisation (5).

6. Dispositif de vaporisation selon la revendication 1, **caractérisé en ce que** les zones (2, 4, 5) sont constituées par différentes sections transversales géométriques du creuset (6), ce qui fait varier la résistance électrique dans les zones (2, 4, 5).

7. Dispositif de vaporisation selon la revendication 1, **caractérisé en ce que** les zones (2, 4, 5) sont composées de matériaux ayant une conductivité électrique différente.

8. Dispositif de vaporisation selon la revendication 1, **caractérisé en ce que** la zone de réchauffement (4) est réalisée en forme de canal.

9. Dispositif de vaporisation selon la revendication 1, **caractérisé en ce que** la zone de fusion (2) et la zone de vaporisation (5) sont réalisées en forme de cuvette cylindrique.

10. Dispositif de vaporisation selon la revendication 1, **caractérisé en ce que** les points les plus bas des zones (2, 4, 5) se situent à un niveau différent.

11. Dispositif de vaporisation selon la revendication 1, **caractérisé en ce que** les points les plus bas des zones (2, 4, 5) se situent au même niveau.

12. Dispositif de vaporisation selon la revendication 1, **caractérisé en ce que** le point le plus bas de la zone de réchauffement (4) se situe à un niveau plus élevé que les points les plus bas de la zone de fusion (2) et de la zone de vaporisation (5).

13. Dispositif de vaporisation selon la revendication 12, **caractérisé en ce que** la zone de réchauffement (4) présente une pente en direction de la zone de vaporisation (5).

14. Dispositif de vaporisation selon la revendication 1, **caractérisé en ce que** la zone de fusion (2) et la zone de vaporisation (5) présentent une forme de base rectangulaire.

15. Dispositif de vaporisation selon la revendication 1, **caractérisé en ce que** la zone de fusion (2) et la zone de vaporisation (5) présentent une forme de base ronde.

16. Dispositif de vaporisation selon la revendication 1, **caractérisé en ce que** le creuset (6) est composé d'un composé à haute fusion qui fait partie des borures, nitrures et/ou carbures métalliques ainsi que des borures, nitrures et/ou carbures et/ou graphites non métalliques ou leurs mélanges.

17. Dispositif de vaporisation selon la revendication 16, **caractérisé en ce que** le creuset (6) contient du TiB₂ et du BN.

18. Dispositif de vaporisation selon la revendication 1, **caractérisé en ce qu'**il est utilisé pour la vaporisation de métaux.

19. Dispositif de vaporisation selon la revendication 1, **caractérisé en ce que** plusieurs creusets (45-54) sont disposés les uns près des autres et qu'un substrat (65) se déplace le long de l'axe longitudinal de ces creusets (45-54).

20. Dispositif de vaporisation selon la revendication 19, **caractérisé en ce que**, pour chaque creuset (45-54), il est prévu un acheminement propre pour un fil (55-64), l'extrémité de ce fil (55-64) étant guidée dans la zone de fusion (2) d'un creuset (45-54).
